# EUROPEAN PATENT APPLICATION

(11) **EP 2 709 123 A2**
(43) Date of publication of application: **19.03.2014**
(21) Application number: 13183924.3
(22) Date of filing: 11.09.2013
(51) Int. Cl.: H01F 27/06, H02M 3/335

(54) **Power supply device**

(30) Priority: 14.09.2012 JP 2012203165
(71) Applicant: Funai Electric Co., Ltd., Osaka 574-0013 (JP)
(72) Inventor: Miyamoto, Hitoshi, Daito-shi, Osaka 574-0013 (JP); Jinnouchi, Takashi, Daito-shi, Osaka 574-0013 (JP)
(74) Representative: Grünecker, Kinkeldey, Stockmair & Schwanhäusser

(57) **Abstract**

This power supply device (10) includes a substrate (11), a transformer (12) mounted on a first surface of the substrate, and a switch element (13) electrically connected to the transformer, mounted on a second surface of the substrate, while the switch element is arranged in a position different from a position on the second surface corresponding to a position on the first surface in which the transformer is mounted.

## Description

### BACKGROUND OF THE INVENTION

### Field of the Invention

The present invention relates to a power supply device, and more particularly, it relates to a power supply device including a transformer and a switch element mounted on a substrate.

### Description of the Background Art

A power supply device including a transformer and a switch element mounted on a substrate is know in general, as disclosed in Japanese Patent Laying-Open No. 5-121885 (1993).

Japanese Patent Laying-Open No. 5-121885 discloses a switching power supply device including a metal core substrate, a transformer mounted on the front surface of the metal core substrate, and a switching element mounted on the rear surface of the metal core substrate. In this switching power supply device, the transformer and the switching element are mounted in positions on the front surface and the rear surface corresponding to each other (positions opposed to (overlapping with) each other through the metal core substrate).

In the switching power supply device disclosed in Japanese Patent Laying-Open No. 5-121885, however, the transformer and the switching element are mounted in the positions on the front surface and the rear surface of the metal core substrate corresponding to each other, whereby heat generated from the transformer is disadvantageously easily transferred to the switching element, and heat generated from the switching element is disadvantageously easily transferred to the transformer. Therefore, the transformer and the switching element disadvantageously easily malfunction by each other's heat generation.

### SUMMARY OF THE INVENTION

The present invention has been proposed in order to solve the aforementioned problem, and an object of the present invention is to provide a power supply device capable of suppressing malfunction of a transformer and a switch element influenced by each other's heat generation.

In order to attain the aforementioned object, a power supply device according to an aspect of the present invention includes a substrate, a transformer mounted on a first surface of the substrate, and a switch element electrically connected to the transformer, mounted on a second surface of the substrate, while the switch element is arranged in a position different from a position on the second surface corresponding to a position on the first surface in which the transformer is mounted.

The power supply device according to the aspect of the present invention is configured as described above, whereby unlike the case where the transformer and the switch element are mounted in positions on the first surface and the second surface of the substrate corresponding to (overlapping with) each other, heat generated from the transformer can be inhibited from being transferred to the switch element, and heat generated from the switch element can be inhibited from being transferred to the transformer. Consequently, malfunction of the transformer and the switch element influenced by each other's heat generation can be suppressed.

In the aforementioned power supply device according to the aspect, the transformer and the switch element are preferably arranged in positions on the first surface and the second surface of the substrate not overlapping with each other. According to this structure, unlike the case where the transformer and the switch element overlap with each other, malfunction of the transformer and the switch element influenced by each other's heat generation can be further suppressed.

In this case, the transformer and the switch element are preferably arranged separately from each other in a direction along the first surface and the second surface of the substrate. According to this structure, unlike the case where the transformer and the switch element are separated from each other in a direction perpendicular to the first surface and the second surface of the substrate, malfunction of the transformer and the switch element influenced by each other's heat generation can be further suppressed.

In the aforementioned power supply device according to the aspect, the substrate is preferably set in a state standing with respect to a horizontal plane, and the switch element is preferably arranged in a vertical position lower than the vertical position of the transformer. According to this structure, the transformer is arranged in a position where heat is more easily released than in the position of the switch element (the vertical position higher than the vertical position of the switch element), and hence malfunction of the switch element influenced by heat generation from the transformer can be further suppressed. This structure is particularly effective for the switch element easily malfunctioning by heat generation.

In this case, the transformer and the switch element are preferably arranged separately from each other in a direction along the vertical direction of the substrate. According to this structure, unlike the case where the transformer and the switch element are separated from each other in the horizontal direction of the substrate, regions (areas) of the first surface and the second surface of the substrate influenced by the heat of the transformer and the switch element both generating heat can be reduced.

In the aforementioned power supply device according to the aspect, the switch element preferably includes a transistor device having a first terminal generating heat, a second terminal, and a control terminal for control, and the second terminal and the control terminal are preferably arranged in a region other than a heat diffusion region on the second surface of the substrate to which the heat generated from the first terminal is diffused. According to this structure, the second terminal and the control terminal are arranged in positions hardly influenced by heat generation from the first terminal, and hence the heat generation from the first terminal can be inhibited from exerting a bad influence on the second terminal and the control terminal.

In this case, the transistor device is preferably mounted such that the second terminal and the control terminal are not arranged above the first terminal. According to this structure, the heat generation from the first terminal can be easily inhibited from exerting a bad influence on the second terminal and the control terminal.

In the aforementioned power supply device including the transistor device mounted such that the second terminal and the control terminal are not arranged above the first terminal, the transformer preferably includes a plurality of terminal portions connected to a winding, the substrate preferably includes a first wire connecting at least one of the plurality of terminal portions to the first terminal, a second wire connecting at least one of the plurality of terminal portions to the second terminal, and a third wire connecting at least one of the plurality of terminal portions to the control terminal on the side of the second surface, and the plurality of terminal portions, the first terminal, the second terminal, and the control terminal are preferably placed such that the first wire, the second wire, and the third wire do not intersect with each other. According to this structure, the first wire, the second wire, and the third wire can be inhibited from intersecting and interfering with each other, whereby malfunction of the transformer and the transistor device and heat generation from the transformer and the transistor device can be suppressed.

In this case, the transformer preferably includes a primary winding on the primary side, the power supply device preferably further includes a capacitor having a first electrode connected to the primary winding and a second electrode connected to the second terminal of the transistor device, and the second wire preferably includes a fourth wire connecting the primary winding to the first electrode of the capacitor. According to this structure, the fourth wire connected to the capacitor and the other wires can be inhibited from interacting and interfering with each other, whereby malfunction of the transformer and the transistor device and heat generation from the transformer and the transistor device can be suppressed.

In the aforementioned power supply device including the first wire, the second wire, and the third wire, the transformer preferably includes an auxiliary winding on the primary side, the power supply device preferably further includes a resistor having a first side connected to the second terminal of the transistor device and a second side connected to the auxiliary winding, and the second wire preferably includes a fifth wire connecting the second side of the resistor to the auxiliary winding. According to this structure, the fifth wire connected to the resistor and the other wires can be inhibited from interacting and interfering with each other, whereby malfunction of the transformer and the transistor device and heat generation from the transformer and the transistor device can be suppressed.

In the aforementioned power supply device including the first wire, the second wire, and the third wire, the transistor device preferably includes a rectangular body portion and has the first terminal formed on a first side surface of the body portion and the second terminal and the control terminal both formed on a second side surface of the body portion opposed to the first side surface, and the transformer and the transistor device are preferably mounted on the substrate such that the plurality of terminal portions are opposed to a side surface other than the first side surface and the second side surface and the control terminal is closer to the plurality of terminal portions than the second terminal. According to this structure, the first wire, the second wire, and the third wire can be easily inhibited from intersecting with each other.

In the aforementioned power supply device in which the transformer includes the plurality of terminal portions, the transistor device preferably includes a rectangular body portion and has the first terminal formed on a first side surface of the body portion and the second terminal and the control terminal both formed on a second side surface of the body portion opposed to the first side surface, and the transformer and the transistor device are preferably mounted on the substrate such that the plurality of terminal portions are opposed to the first side surface. According to this structure, the first wire, the second wire, and the third wire can be easily inhibited from intersecting with each other.

In the aforementioned power supply device according to the aspect, the protrusion height of the switch element from the second surface of the substrate is preferably smaller than the protrusion height of the transformer from the first surface of the substrate. According to this structure, when a display portion or the like is arranged on the second surface side of the substrate, for example, the protrusion height of the switch element from the second surface is smaller, so that an interval between the substrate and the display portion can be reduced.

In the aforementioned power supply device according to the aspect, the transformer is preferably so formed that the plane area thereof is larger than the plane area of the switch element, and the transformer having a larger plane area is preferably arranged in a vertical position higher than the vertical position of the switch element. According to this structure, the transformer having the larger plane area (i.e., having a larger heat diffusion region) is arranged above, and hence a region not influenced by heat below the transformer can be increased.

In the aforementioned power supply device according to the aspect, the transformer preferably includes a terminal portion connected to a primary winding on the primary side and a terminal portion connected to a secondary winding on the secondary side, and the terminal portion connected to the primary winding is preferably arranged in a vertical position lower than the vertical position of the terminal portion connected to the secondary winding. According to this structure, the switch element is connected to the terminal portion connected to the primary winding, whereby the switch element can be easily arranged below the transformer.

According to the present invention, as hereinabove described, malfunction of the transformer and the switch element influenced by each other's heat generation can be suppressed.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a schematic view showing the structure of a display device mounted with a power supply device according to a first embodiment of the present invention;
Fig. 2 is a circuit diagram of the power supply device according to the first embodiment of the present invention;
Fig. 3 is a schematic view showing a substrate of the power supply device according to the first embodiment of the present invention as viewed from the rear surface side;
Fig. 4 is a schematic view showing a heat diffusion region on the rear surface of the substrate of the power supply device according to the first embodiment of the present invention;
Fig. 5 is a schematic view showing a substrate of a power supply device according to a second embodiment of the present invention as viewed from the rear surface side;
Fig. 6 is a schematic view showing a heat diffusion region on the rear surface of the substrate of the power supply device according to the second embodiment of the present invention; and
Fig. 7 is a schematic view showing a substrate of a power supply device according to a modification of the first and second embodiments of the present invention as viewed from the rear surface side.

### DESCRIPTION OF THE PREFERRED EMBODIMENTS

Embodiments of the present invention are hereinafter described with reference to the drawings.

### (First Embodiment)

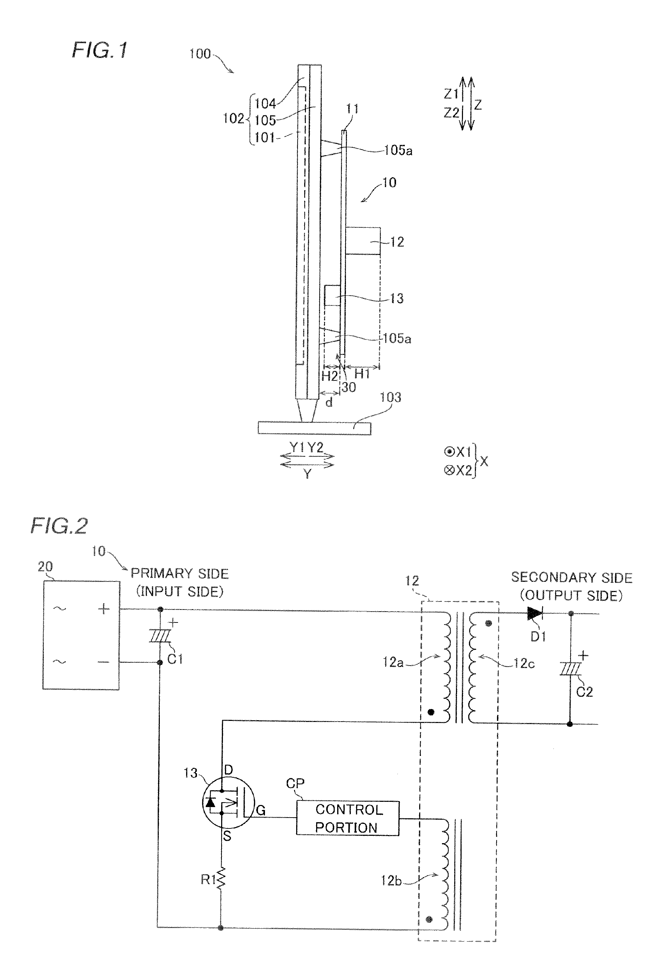

The structure of a display device 100 employing a power supply device 10 according to a first embodiment of the present invention is now described with reference to Figs. 1 to 4. The power supply device 10 is an example of the "power supply portion" in the present invention.

As shown in Fig. 1, the display device 100 includes a display device body 102 including a display portion 101 displaying an image and a support member 103 supporting the display device body 102 from below (arrow Z2 direction side). The display device 100 is set perpendicularly to a horizontal plane (a plane extending in a direction X and a direction Y).

The display device body 102 of the display device 100 includes the display portion 101, a front housing 104 of resin holding the display portion 101 from the front surface side (arrow Y1 direction side), and a rear housing 105 of sheet metal holding the display portion 101 from the rear surface side (arrow Y2 direction side). The rear housing 105 is provided with a substrate mounting portion 105a protruding rearward (arrow Y2 direction side) from the rear surface of the rear housing 105, and this substrate mounting portion 105a is mounted with a substrate 11, described later, of the power supply device 10. A portion of the rear surface of the rear housing 105 mounted with the power supply device 10 is covered with an unshown cover member of resin not to expose the power supply device 10.

The power supply device 10 includes the flat platelike substrate 11 set in a state standing perpendicularly to the horizontal plane (the plane extending in the direction X and the direction Y), a transformer 12 mounted on the front surface (the surface on the arrow Y2 direction side) of the substrate 11, and an FET (field effect transistor) 13 mounted on the rear surface (the surface on the arrow Y1 direction side) of the substrate 11. The FET 13 is an example of the "switch element" or the "transistor device" in the present invention. The power supply device 10 is connected to an external power supply (alternating current source) 20 (see Fig. 2) through an unshown connection cable.

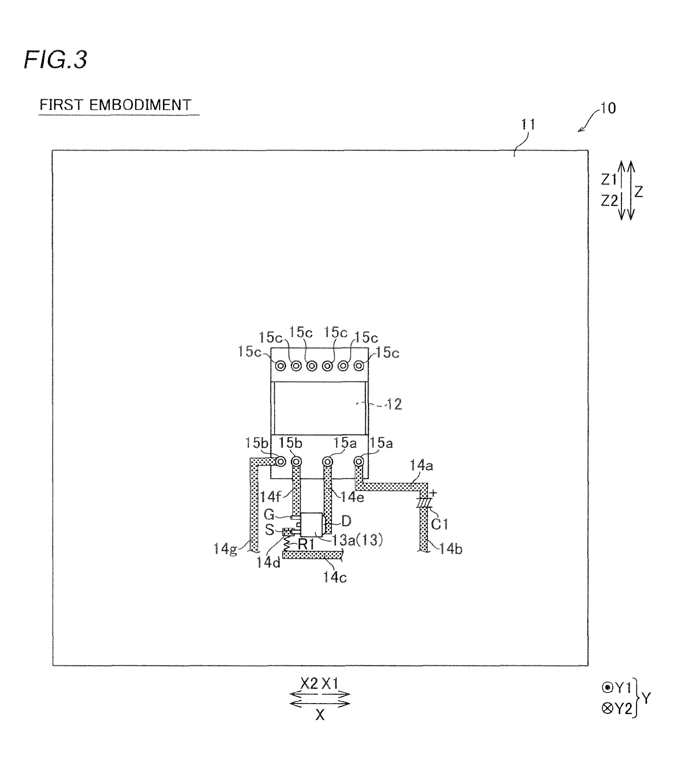

The substrate 11 is set parallel to the rear surface (the surface of the rear housing 105 on the arrow Y2 direction side) of the display device 100. The transformer 12 and the FET 13 are connected to each other through wiring patterns 14a, 14b, 14c, 14d, 14e, 14f, and 14g (see dot-meshed portions in Fig. 3: the details are described later) formed on the rear surface (the surface on the arrow Y1 direction side) of the substrate 11. The protrusion height (the height in the direction Y) H1 of the transformer 12 from the front surface (the surface on the arrow Y2 direction side) of the substrate 11 is larger than the protrusion height H2 of the FET 13 from the rear surface of the substrate 11.

According to the first embodiment, the FET 13 is arranged in a position different from a position on the rear surface corresponding to a position on the front surface of the substrate 11 mounted with the transformer 12. Specifically, the transformer 12 and the FET 13 are arranged in positions on the front and rear surfaces of the substrate 11 not overlapping with each other. More specifically, the transformer 12 and the FET 13 are arranged separately from each other in a direction (direction Z) along the front and rear surfaces of the substrate 11. Thus, the FET 13 is arranged below (arrow Z2 direction side) the transformer 12. In other words, the FET 13 is arranged in a vertical position lower than the vertical position of the transformer 12 with respect to the horizontal plane (the plane extending in the direction X and the direction Y). The transformer 12 is so formed that the plane area thereof is larger than the plane area of the FET 13, and the transformer 12 having the larger plane area is arranged in a vertical position higher than the vertical position of the FET 13.

According to the first embodiment, the substrate 11 and the rear surface (the surface of the rear housing 105 on the arrow Y2 direction side) of the display device 100 are arranged to be separated from each other with a prescribed clearance 30. The interval (thickness in the direction Y) d of this clearance 30 is set to be larger than the protrusion height H2 (the height in the direction Y) of the FET 13 from the substrate 11. For example, the interval d of the clearance 30 is set to be at least about 3 mm when the protrusion height H2 of the FET 13 is about 2.5 mm.

The circuit structure of the power supply device 10 according to the first embodiment is now described with reference to Fig. 2.

As shown in Fig. 2, the power supply device 10 includes the transformer 12, a capacitor C1, the FET 13, a control portion CP, and a resistor R1 arranged on the primary side (input side) of the transformer 12, and a diode D1 and a capacitor C2 arranged on the secondary side (output side) of the transformer 12. The transformer 12 includes a primary winding 12a and an auxiliary winding 12b on the primary side and a secondary winding 12c on the secondary side. The winding direction of the primary winding 12a is opposite to the winding direction of the secondary winding 12c. The winding direction of the primary winding 12a is the same as the winding direction of the auxiliary winding 12b.

The primary winding 12a functions as a main winding for exciting the secondary winding 12c. In other words, the secondary winding 12c is configured to be excited when large current (principal current) flows from the external power supply (alternating current source) 20 to the primary winding 12a thereby exciting the primary winding 12a. The FET 13 is provided to switch ON/OFF of the aforementioned large current (principal current) flowing from the external power supply 20 to the primary winding 12a. The control portion CP is provided to control ON/OFF of the FET 13. The control portion CP is configured to perform on-off control of the FET 13 described above with power supplied from the auxiliary winding 12b. In other words, the auxiliary winding 12b functions as a drive winding for driving the FET 13. Thus, the control portion CP is configured to perform on-off control of the FET 13, whereby a voltage on the primary side (primary winding 12a) of the transformer 12 is transformed to be transferred to the secondary side (secondary winding 12c).

A first end of the primary winding 12a is connected to a first electrode of the capacitor C1. A second end of the primary winding 12a is connected to a drain terminal D of the FET 13. A gate terminal G of the FET 13 is connected to a first end of the auxiliary winding 12b through the control portion CP. A source terminal S of the FET 13 is connected to a second end of the auxiliary winding 12b through the resistor R1 and is connected to a second electrode of the capacitor C1 through the resistor R1 The first electrode and the second electrode of the capacitor C1 are connected to the positive side (+) and the negative side (-) of the external power supply 20, respectively. The drain terminal D, the source terminal S, and the gate terminal G of the FET 13 are examples of the "first terminal", the "second terminal", and the control terminal" in the present invention, respectively.

A first end of the secondary winding 12c is connected to a first electrode of the capacitor C2 through the diode D1. A second end of the secondary winding 12c is connected to a second electrode of the capacitor C2. Both the first electrode and the second electrode of the capacitor C2 are connected to an unshown load (such as a signal processing substrate for performing processing of a video signal mounted on the display device 100 separately from the power supply device 10) connected to the output side of the power supply device 10.

The wiring patterns 14a to 14g (see the dot-meshed portions) for connecting the transformer 12 and the FET 13 to each other formed on the rear surface (the surface on the arrow Y1 direction side) of the substrate 11 of the power supply device 10 according to the first embodiment are now described with reference to Fig. 3.

As shown in Fig. 3, two connection terminal portions 15a connected to the primary winding 12a (see Fig. 2) of the transformer 12 mounted on the front surface (the surface on the arrow Y2 direction side) of the substrate 11 and two connection terminal portions 15b connected to the auxiliary winding 12b (see Fig. 2) are provided on the rear surface (the surface on the arrow Y1 direction side) of the substrate 11. Both the connection terminal portions 15a and 15b are examples of the "terminal portion" in the present invention. Furthermore, six connection terminal portions 15c connected to the secondary winding 12c (see Fig. 2) of the transformer 12 are provided in a region above (arrow Z1 direction side) the connection terminal portions 15a and 15b on the rear surface (the surface on the arrow Y1 direction side) of the substrate 11.

According to the first embodiment, the FET 13 is configured such that the drain terminal D is not arranged below (arrow Z1 direction side) the source terminal S and the gate terminal G provided on the side opposite to the drain terminal D. Specifically, the FET 13 includes a rectangular body portion 13a, the drain terminal D is provided on a first side surface (the side surface on the arrow X1 direction side) of the body portion 13a, and the source terminal S and the gate terminal G are provided on a second side surface (the side surface on the arrow X2 direction side) of the body portion 13a opposed to the first side surface. The connection terminal portions 15a and 15b are opposed to side surfaces (both side surfaces in the direction Z) other than the aforementioned first and second side surfaces of the body portion 13a, and the gate terminal G is arranged closer to the connection terminal portions 15a and 15b than the source terminal S.

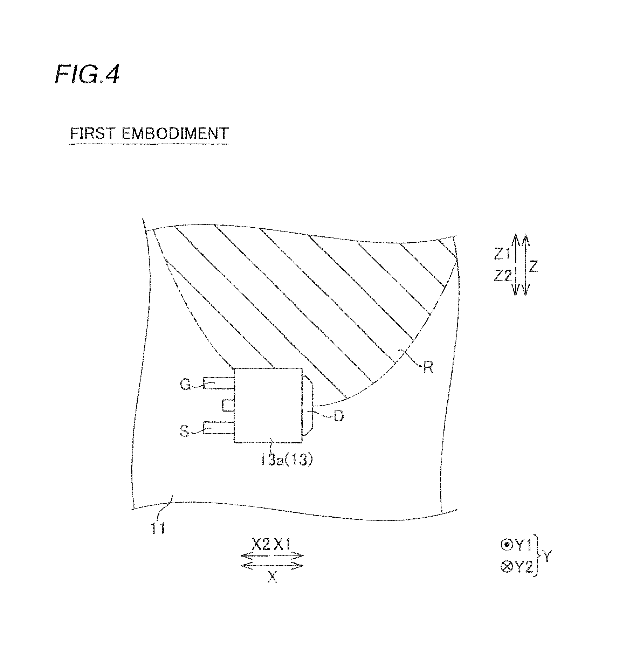

More specifically, the FET 13 is mounted on the rear surface of the substrate 11 such that the drain terminal D faces to the right (arrow X1 direction side) and both the source terminal S and the gate terminal G face to the left (arrow X2 direction side). Thus, both the source terminal S and the gate terminal G are arranged in a region other than a heat diffusion region R (see a shaded area on the concave side of a parabolic curve (see a dashed line) shown in Fig. 4) on the rear surface of the substrate 11 to which heat from the drain terminal D is diffused. The capacitor C1 (see Fig. 2) is mounted in a right region with respect to the transformer 12 on the rear surface of the substrate 11. Furthermore, the resistor R1 (see Fig. 2) is mounted in a region near the left side of the FET 13 on the rear surface of the substrate 11.

According to the first embodiment, the connection terminal portions 15a and 15b, the drain terminal D, the source terminal S, and the gate terminal G are placed such that the wiring patterns 14a to 14e (the details are described later) connecting the connection terminal portions 15a to the drain terminal D and the source terminal S of the FET 13 and the wiring patterns 14c, 14d, 14f, and 14g (the details are described later) connecting the connection terminal portions 15b to the source terminal S and the gate terminal G of the FET 13 do not intersect with each other. Specifically, the connection terminal portions 15a and 15b are arranged on the right side (arrow X1 direction side) and the left side (arrow X2 direction side), respectively, as viewed from the rear surface (the surface on the arrow Y1 direction side) of the substrate 11. The drain terminal D is arranged to face to the right (the side of the connection terminal portions 15a), as described above. Both the source terminal S and the gate terminal G are arranged to face to the left (the side of the connection terminal portions 15b). The gate terminal G is arranged on the side closer to the connection terminal portions 15b (upper side: arrow Z1 direction side) as compared with the source terminal S.

As shown in Fig. 3, a right (arrow X1 direction side) connection terminal portion 15a (corresponding to the first end of the primary winding 12a in Fig. 2) of the two connection terminal portions 15a is connected to the source terminal S of the FET 13 through the wiring pattern 14a having two short portions extending vertically (in the direction Z) and one long portion extending horizontally (in the direction X), the capacitor C1, the wiring pattern 14b extending vertically, the wiring pattern 14c extending horizontally, the resistor R1, and the wiring pattern 14d extending horizontally. These wiring patterns 14a to 14d are examples of the "second wire" in the present invention. The wiring pattern 14a is an example of the "fourth wire" in the present invention. In Fig. 3, illustration of a wiring pattern between the wiring pattern 14b and the wiring pattern 14c is omitted. A left (arrow X2 direction side) connection terminal portion 15a (corresponding to the second end of the primary winding 12a in Fig. 2) of the two connection terminal portions 15a is connected to the drain terminal D of the FET 13 through the wiring pattern 14e extending vertically. This wiring pattern 14e is an example of the "first wire" in the present invention.

A right (arrow X1 direction side) connection terminal portion 15b (corresponding to the first end of the secondary winding 12c in Fig. 2) of the two connection terminal portions 15b is connected to the gate terminal G of the FET 13 through the wiring pattern 14f extending vertically (in the direction Z). This wiring pattern 14f is an example of the "third wire" in the present invention. In Fig. 3, illustration of the control portion CP provided between the first end of the secondary winding 12c and the gate terminal G in Fig. 2 is omitted. A left (arrow X2 direction side) connection terminal portion 15b (corresponding to the second end of the secondary winding 12c in Fig. 2) of the two connection terminal portions 15b is connected to the source terminal S of the FET 13 through the wiring pattern 14g having a short portion extending horizontally (in the direction X) and a long portion extending vertically (in the direction Z), the wiring pattern 14c, the resistor R1, and the wiring pattern 14d. In Fig. 3, illustration of a wiring pattern between the wiring pattern 14g and the wiring pattern 14c is omitted. The wiring pattern 14g is an example of the "second wire" or the "fifth wire" in the present invention.

According to the first embodiment, as hereinabove described, the transformer 12 and the FET 13 are arranged separately from each other in the direction along the front surface and the rear surface (the both surfaces in the direction Y) of the substrate 11. Thus, unlike the case where the transformer 12 and the FET 13 are mounted in positions on the front surface and the rear surface of the substrate 11 corresponding to (overlapping with) each other, heat generated from the transformer 12 can be inhibited from being transferred to the FET 13, and heat generated from the FET 13 can be inhibited from being transferred to the transformer 12. Consequently, malfunction of the transformer 12 and the FET 13 influenced by each other's heat generation can be suppressed.

According to the first embodiment, as hereinabove described, the transformer 12 and the FET 13 are arranged in the positions on the front surface and the rear surface of the substrate 11 not overlapping with each other. Thus, unlike the case where the transformer 12 and the FET 13 overlap with each other, malfunction of the transformer 12 and the FET 13 influenced by each other's heat generation can be further suppressed.

According to the first embodiment, as hereinabove described, the transformer 12 and the FET 13 are arranged separately from each other in the direction along the front surface and the rear surface of the substrate 11. Thus, unlike the case where the transformer 12 and the FET 13 are separated from each other in a direction perpendicular to the front surface and the rear surface of the substrate 11, malfunction of the transformer 12 and the FET 13 influenced by each other's heat generation can be further suppressed.

According to the first embodiment, as hereinabove described, the substrate 11 is set in the state standing perpendicularly to the horizontal plane (the plane extending in the direction X and the direction Y), and the FET 13 is arranged in the vertical position lower than the vertical position of the transformer 12. Thus, the transformer 12 is arranged in a position where heat is more easily released than in the position of the FET 13 (the vertical position higher than the vertical position of the FET 13), and hence malfunction of the FET 13 influenced by heat generation from the transformer 12 can be further suppressed. This structure is particularly effective for the FET 13 easily malfunctioning by heat generation.

According to the first embodiment, as hereinabove described, the transformer 12 and the FET 13 are arranged separately from each other in a direction along the vertical direction of the substrate 11. Thus, unlike the case where the transformer 12 and the FET 13 are separated from each other in the horizontal direction of the substrate 11, regions (areas) of the front surface and the rear surface of the substrate 11 influenced by the heat of the transformer 12 and the FET 13 both generating heat can be reduced.

According to the first embodiment, as hereinabove described, the source terminal S and the gate terminal G are arranged in the region other than the heat diffusion region R (see the shaded area on the concave side of the parabolic curve (see the dashed line) shown in Fig. 4) on the rear surface of the substrate 11 to which the heat from the drain terminal D is diffused. Thus, the source terminal S and the gate terminal G are arranged in positions hardly influenced by heat generation from the drain terminal D, and hence the heat generation from the drain terminal D can be inhibited from exerting a bad influence on the source terminal S and the gate terminal G.

According to the first embodiment, as hereinabove described, the FET 13 is configured such that the drain terminal D is not arranged below (arrow Z1 direction side) the source terminal S and the gate terminal G. The drain terminal D of the FET 13 easily generates heat by inflow of large current (principal current) from the primary winding 12a of the transformer 12. In this case, according to the first embodiment, the source terminal S and the gate terminal G of the FET 13 are arranged in the positions hardly influenced by heat generation from the drain terminal D, and hence the heat generation from the drain terminal D can be easily inhibited from exerting a bad influence on the source terminal S and the gate terminal G.

According to the first embodiment, as hereinabove described, the connection terminal portions 15a and 15b, the drain terminal D, the source terminal S, and the gate terminal G are placed such that the wiring patterns 14a to 14e connecting the connection terminal portions 15a to the drain terminal D and the source terminal S and the wiring patterns 14c, 14d, 14f, and 14g connecting the connection terminal portions 15b to the source terminal S and the gate terminal G do not intersect with each other. Thus, the wiring patterns 14a to 14e connecting the connection terminal portions 15a to the drain terminal D and the source terminal S and the wiring patterns 14c, 14d, 14f, and 14g connecting the connection terminal portions 15b to the source terminal S and the gate terminal G can be inhibited from intersecting and interfering with each other, whereby malfunction of the transformer 12 and the FET 13 and heat generation from the transformer 12 and the FET 13 can be suppressed.

According to the first embodiment, as hereinabove described, the capacitor C1 having the first electrode connected to the primary winding 12a and the second electrode connected to the source terminal S of the FET 13 is provided, and the primary winding 12a and the first electrode of the capacitor C1 are connected to each other by the wiring pattern 14a. Thus, the wiring pattern 14a connected to the capacitor C1 and the other wires can be inhibited from interacting and interfering with each other, whereby malfunction of the transformer 12 and the FET 13 and heat generation from the transformer 12 and the FET 13 can be suppressed.

According to the first embodiment, as hereinabove described, the resistor R1 having a first side connected to the source terminal S of the FET 13 and a second side connected to the auxiliary winding 12b is provided, and the second side of the resistor R1 and the auxiliary winding 12b are connected to each other by the wiring pattern 14g. Thus, the wiring pattern 14g connected to the resistor R1 and the other wires can be inhibited from interacting and interfering with each other, whereby malfunction of the transformer 12 and the FET 13 and heat generation from the transformer 12 and the FET 13 can be suppressed.

According to the first embodiment, as hereinabove described, the connection terminal portions 15a and the connection terminal portions 15b are arranged on the right side (arrow X1 direction side) and the left side (arrow X2 direction side), respectively, as viewed from the rear surface (the surface on the arrow Y1 direction side) of the substrate 11. Furthermore, the drain terminal D of the FET 13 is arranged on the side of the connection terminal portions 15a (the right side), and the gate terminal G is arranged on the side closer to the connection terminal portions 15b (upper side: arrow Z1 direction side) as compared with the source terminal S. When the connection terminal portions 15a, the connection terminal portions 15b, the drain terminal D, the source terminal S, and the gate terminal G are arranged in this manner, the wiring patterns 14a to 14e connecting the connection terminal portions 15a to the drain terminal D and the source terminal S and the wiring patterns 14e, 14d, 14f, and 14g connecting the connection terminal portions 15b to the source terminal S and the gate terminal G can be easily inhibited from intersecting with each other.

According to the first embodiment, as hereinabove described, the rear surface (the surface of the rear housing 105 on the arrow Y2 direction side) of the display device 100 and the substrate 11 are arranged to be separated from each other with the prescribed clearance 30. Thus, the prescribed clearance 30 between the rear surface of the display device 100 and the substrate 11 can suppress transfer of heat generated from the transformer 12 and the FET 13 mounted on the substrate 11 to the display device 100. Furthermore, the heat generated from the transformer 12 and the FET 13 can be easily released upward (arrow Z1 direction side) through the prescribed clearance 30.

According to the first embodiment, as hereinabove described, the protrusion height H2 of the FET 13 from the rear surface of the substrate 11 is rendered smaller than the protrusion height H1 of the transformer 12 from the front surface of the substrate 11. Thus, when the display portion 101 is arranged on the rear surface side of the substrate 11, the protrusion height H2 of the FET 13 from the rear surface is smaller, so that an interval between the substrate 11 and the display portion 101 can be reduced.

According to the first embodiment, as hereinabove described, the transformer 12 is so formed that the plane area thereof is larger than the plane area of the FET 13, and the transformer 12 having the larger plane area is arranged in the vertical position higher than the vertical position of the FET 13. Thus, the transformer 12 having the larger plane area (i.e., having a larger heat diffusion region) is arranged above, and hence a region not influenced by heat below the transformer 12 can be increased.

According to the first embodiment, as hereinabove described, the interval d of the prescribed clearance 30 is set to be equal to or larger than the protrusion height H2 of the FET 13 from the substrate 11. Thus, the FET 13 can be easily arranged in the prescribed clearance 30 between the display portion 101 and the substrate 11.

According to the first embodiment, as hereinabove described, the connection terminal portions 15a connected to the primary winding 12a are arranged in vertical positions lower than the vertical positions of the connection terminal portions 15c connected to the secondary winding 12c. Thus, the FET 13 is connected to the connection terminal portions 15a connected to the primary winding 12a, whereby the FET 13 can be easily arranged below the transformer 12.

### (Second Embodiment)

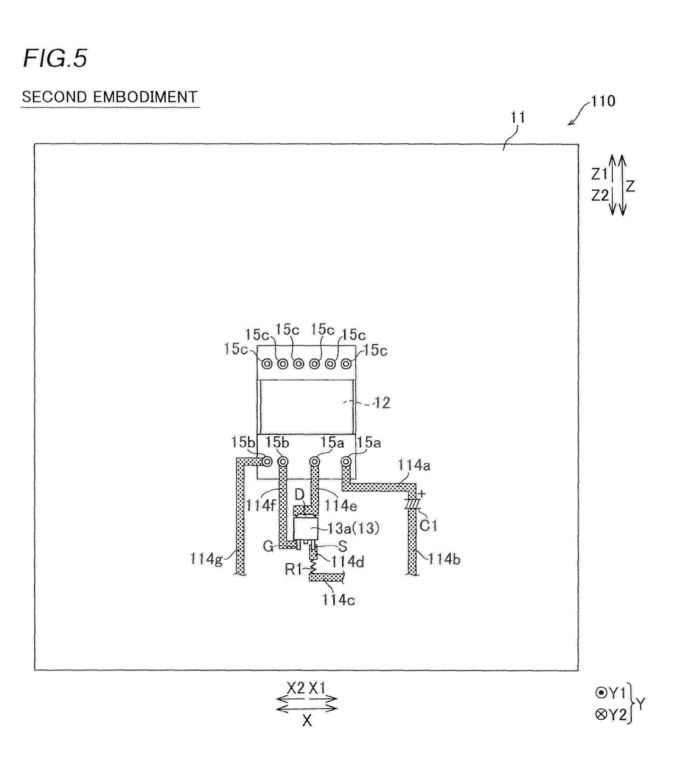

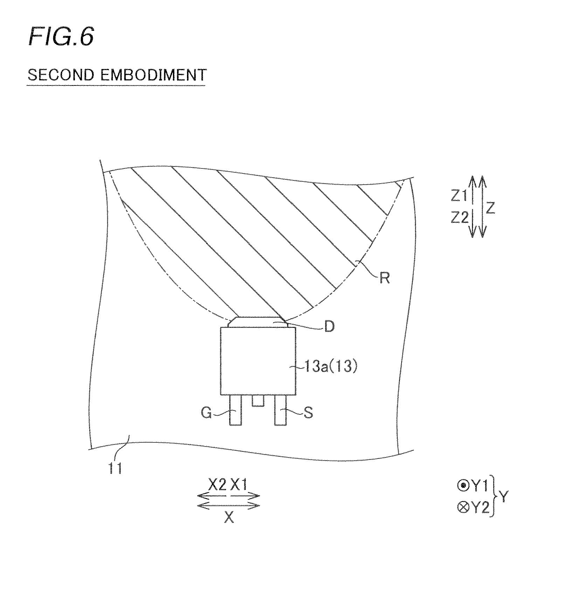

A power supply device 110 according to a second embodiment is now described with reference to Figs. 5 and 6. In this second embodiment, the drain terminal D of an FET 13 is arranged to face to the side of a transformer 12 (upper side: arrow Z1 direction side), unlike in the aforementioned first embodiment in which the drain terminal D of the FET 13 is arranged to face to the side of the connection terminal portions 15a (right side: arrow X1 direction side).

As shown in Fig. 5, also in the second embodiment, connection terminal portions 15a and 15b connected to the transformer 12 mounted on the front surface (the surface on the arrow Y2 direction side) of a substrate 11 are provided on the rear surface (the surface on the arrow Y1 direction side) of the substrate 11, like in the aforementioned first embodiment. These connection terminal portions 15a and 15b are arranged on the right side (arrow X1 direction side) and the left side (arrow X2 direction side), respectively, as viewed from the rear surface of the substrate 11. The FET 13 having the drain terminal D and a source terminal S and a gate terminal G provided on the side opposite to the drain terminal D is mounted in a region of the rear surface of the substrate 11 directly under the transformer 12. The connection terminal portions 15a and 15b are connected to the drain terminal D, the source terminal S, and the gate terminal G of the FET 13 through wiring patterns 114a, 114b, 114c, 114d, 114e, 114f, and 114g (see dot-meshed portions) formed on the rear surface of the substrate 11.

Also in the second embodiment, the FET 13 is configured such that the drain terminal D is not arranged below (arrow Z1 direction side) the source terminal S and the gate terminal G, like in the aforementioned first embodiment. Specifically, the drain terminal D of the FET 13 is provided on a first side surface (the side surface on the arrow Z1 direction side) of a body portion 13a, and the source terminal S and the gate terminal G of the FET 13 are provided on a second side surface (the side surface on the arrow Z2 direction side) of the body portion 13a opposed to the first side surface. Furthermore, the connection terminal portions 15a and 15b, the drain terminal D, the source terminal S, and the gate terminal G are placed such that the wiring patterns 114a to 114e (the details are described later) connecting the connection terminal portions 15a to the drain terminal D and the source terminal S and the wiring patterns 114c, 114d, 114f, and 114g (the details are described later) connecting the connection terminal portions 15b to the source terminal S and the gate terminal G do not intersect with each other.

In the second embodiment, the connection terminal portions 15a and 15b are opposed to the first side surface (arrow Z1 direction side) of the body portion 13a, unlike in the aforementioned first embodiment. In other words, the drain terminal D of the FET 13 is arranged to face to the side of the transformer 12 (upper side: arrow Z1 direction side). Both the source terminal S and the gate terminal G of the FET 13 are arranged to face to the side opposite to the transformer 12 (lower side: arrow Z2 direction side). The gate terminal G of the FET 13 is arranged on the side closer to the connection terminal portions 15b (left side: arrow X2 direction side) as compared with the source terminal S. Thus, also in the second embodiment, both the source terminal S and the gate terminal G are arranged in a region other than a heat diffusion region R (see a shaded area on the concave side of a parabolic curve (see a dashed line) shown in Fig. 6) on the rear surface of the substrate 11 to which heat generated from the drain terminal D is diffused, like in the aforementioned first embodiment.

As shown in Fig. 5, a right (arrow X1 direction side) connection terminal portion 15a of the two connection terminal portions 15a is connected to the source terminal S of the FET 13 through the wiring pattern 114a having two short portions extending vertically (in a direction Z) and one long portion extending horizontally (in a direction X), a capacitor C1, the wiring pattern 114b extending vertically, the wiring pattern 114c extending horizontally, a resistor R1, and the wiring pattern 114d extending vertically. These wiring patterns 114a to 114d are examples of the "second wire" in the present invention. In Fig. 5, illustration of a wiring pattern between the wiring pattern 114b and the wiring pattern 114c is omitted. A left (arrow X2 direction side) connection terminal portion 15a of the two connection terminal portions 15a is connected to the drain terminal D of the FET 13 through the wiring pattern 114e having a long portion extending vertically and a short portion extending horizontally. This wiring pattern 114e is an example of the "first wire"' in the present invention.

A right (arrow X1 direction side) connection terminal portion 15b of the two connection terminal portions 15b is connected to the gate terminal G of the FET 13 through the wiring pattern 114f having a long portion extending vertically (in the direction Z) and a short portion extending horizontally (in the direction X). This wiring pattern 114f is an example of the "third wire" in the present invention. A left (arrow X2 direction side) connection terminal portion 15b of the two connection terminal portions 15b is connected to the source terminal S of the FET 13 through the wiring pattern 114g having a short portion extending horizontally (in the direction X) and a long portion extending vertically (in the direction Z), the wiring pattern 114c, the resistor R1, and the wiring pattern 114d. In Fig. 5, illustration of a wiring pattern between the wiring pattern 114g and the wiring pattern 114c is omitted. The wiring pattern 114g is an example of the "second wires' in the present invention.

The remaining structure of the power supply device 110 according to the second embodiment is similar to that of the power supply device 10 according to the aforementioned first embodiment.

According to the second embodiment, as hereinabove described, the drain terminal D of the FET 13 is arranged above (arrow Z1 direction side), and the source terminal S and the gate terminal G of the FET 13 are arranged below (arrow Z2 direction side). Thus, the drain terminal D easily generating heat by inflow of large current (principal current) from the transformer 12 is arranged in a position where heat is more easily released than in the positions of the source terminal S and the gate terminal G (a vertical position higher than the vertical positions of the source terminal S and the gate terminal G), and hence heat generation from the drain terminal D can be further inhibited from exerting a bad influence on the source terminal S and the gate terminal G.

According to the second embodiment, as hereinabove described, the connection terminal portions 15a and the connection terminal portions 15b are arranged on the right side (arrow X1 direction side) and the left side (arrow X2 direction side), respectively, as viewed from the rear surface (the surface on the arrow Y1 direction side) of the substrate 11. Furthermore, the drain terminal D of the FET 13 is arranged on the side of the transformer 12 (upper side: arrow Z1 direction side), and the gate terminal G of the FET 13 is arranged on the side closer to the connection terminal portions 15b (left side: arrow X2 direction side) as compared with the source terminal S. When the connection terminal portions 15a, the connection terminal portions 15b, the drain terminal D, the source terminal S, and the gate terminal G are arranged in this manner, the wiring patterns 114a to 114e connecting the connection terminal portions 15a to the drain terminal D and the source terminal S and the wiring patterns 114c, 114d, 114f, and 114g connecting the connection terminal portions 15b to the source terminal S and the gate terminal G can be easily inhibited from intersecting with each other.

The remaining effects of the second embodiment are similar to those of the aforementioned first embodiment.

The embodiments disclosed this time must be considered as illustrative in all points and not restrictive. The range of the present invention is shown not by the above description of the embodiments but by the scope of claims for patent, and all modifications within the meaning and range equivalent to the scope of claims for patent are further included.

For example, while the power supply device according to the present invention is employed in the display device in each of the aforementioned first and second embodiments, the present invention is not restricted to this. The power supply device according to the present invention is also applicable to a general power supply device other than the power supply device employed in the display device so far as the same includes a substrate, a transformer, and an FET (switching element).

While the transformer is mounted on the front surface of the substrate and the FET is mounted on the rear surface of the substrate in each of the aforementioned first and second embodiments, the present invention is not restricted to this. According to the present invention, the transformer may alternatively be mounted on the rear surface of the substrate, and the FET may alternatively be mounted on the front surface of the substrate.

While the FET is arranged below the transformer in each of the aforementioned first and second embodiments, the present invention is not restricted to this. According to the present invention, the FET and the transformer are simply required to be arranged separately from each other in the direction along the front surface and the rear surface of the substrate, and the FET may alternatively be arranged above the transformer.

While the substrate is set in the state standing perpendicularly to the horizontal plane in each of the aforementioned first and second embodiments, the present invention is not restricted to this. According to the present invention, the substrate may alternatively be set in a state standing in a direction inclined from a direction perpendicular to the horizontal plane.

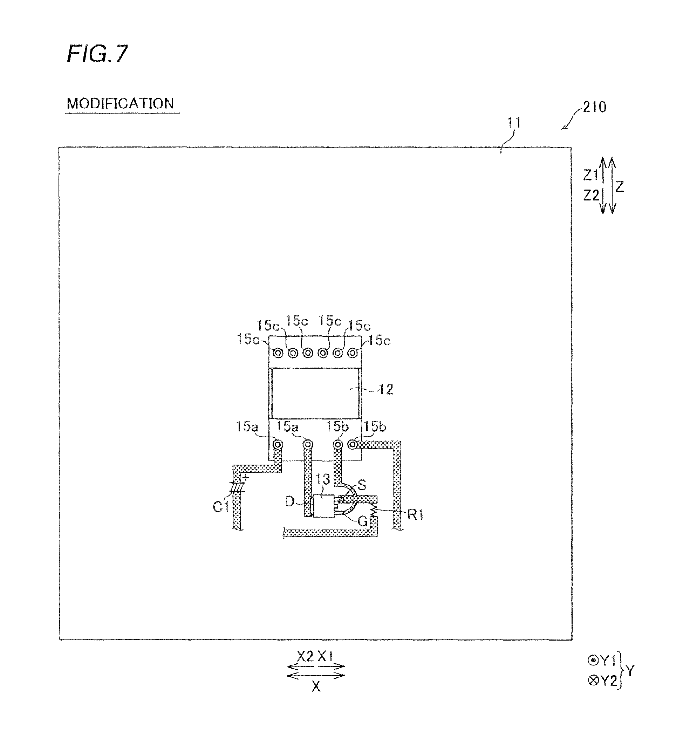

While the drain terminal is not arranged below the source terminal and the gate terminal by mounting the FET such that the drain terminal is arranged on the right side (upper side) and the source terminal and the gate terminal are arranged on the left side (lower side) in each of the aforementioned first and second embodiments, the present invention is not restricted to this. According to the present invention, as in a power supply device 210 according to a modification shown in Fig. 7, an FET 13 may alternatively be mounted such that the drain terminal D thereof is arranged on the left side (arrow X2 direction side) and the source terminal S and the gate terminal G thereof are arranged on the right side (arrow X1 direction side).

While the FET (field effect transistor) is employed as the switch element according to the present invention in each of the aforementioned first and second embodiments, the present invention is not restricted to this. According to the present invention, a transistor (bipolar transistor, for example) other than the FET may alternatively be employed as the switch element, or a switch element (a semiconductor device such as a thyristor) other than the transistor may alternatively be employed.

## Claims

1. A power supply device (10, 110, 210) comprising:
a substrate (11);
a transformer (12) mounted on a first surface of the substrate; and
a switch element (13) electrically connected to the transformer, mounted on a second surface of the substrate, wherein
the switch element is arranged in a position different from a position on the second surface corresponding to a position on the first surface in which the transformer is mounted.

2. The power supply device according to claim 1,
wherein
the transformer and the switch element are arranged in positions on the first surface and the second surface of the substrate not overlapping with each other.

3. The power supply device according to claim 2,
wherein
the transformer and the switch element are arranged separately from each other in a direction along the first surface and the second surface of the substrate.

4. The power supply device according to claim 1,
wherein
the substrate is set in a state standing with respect to a horizontal plane, and
the switch element is arranged in a vertical position lower than a vertical position of the transformer.

5. The power supply device according to claim 4,
wherein
the transformer and the switch element are arranged separately from each other in a direction along a vertical direction of the substrate.

6. The power supply device according to claim 1,
wherein
the switch element includes a transistor device (13) having a first terminal (D) generating heat, a second terminal (S), and a control terminal (G) for control, and
the second terminal and the control terminal are arranged in a region other than a heat diffusion region (R) on the second surface of the substrate to which the heat generated from the first terminal is diffused.

7. The power supply device according to claim 6,
wherein
the transistor device is mounted such that the second terminal and the control terminal are not arranged above the first terminal.

8. The power supply device according to claim 7,
wherein
the transformer includes a plurality of terminal portions (15a, 15b) connected to a winding,
the substrate includes a first wire (14e, 114e) connecting at least one of the plurality of terminal portions to the first terminal, a second wire (14a to 14d, 14g, 114a to 114d, 114g) connecting at least one of the plurality of terminal portions to the second terminal, and a third wire (14f, 114f) connecting at least one of the plurality of terminal portions to the control terminal on a side of the second surface, and
the plurality of terminal portions, the first terminal, the second terminal, and the control terminal are placed such that the first wire, the second wire, and the third wire do not intersect with each other.

9. The power supply device according to claim 8,
wherein
the transformer includes a primary winding (12a) on a primary side,
the power supply device further comprising a capacitor (C1 having a first electrode connected to the primary winding and a second electrode connected to the second terminal of the transistor device, wherein
the second wire includes a fourth wire (14a) connecting the primary winding to the first electrode of the capacitor.

10. The power supply device according to claim 8,
wherein
the transformer includes an auxiliary winding (12b) on a primary side,
the power supply device further comprising a resistor having a first side connected to the second terminal of the transistor device and a second side connected to the auxiliary winding, wherein
the second wire includes a fifth wire (14g) connecting the second side of the resistor to the auxiliary winding.

11. The power supply device according to claim 8,
wherein
the transistor device includes a rectangular body portion (13a) and has the first terminal formed on a first side surface of the body portion and the second terminal and the control terminal both formed on a second side surface of the body portion opposed to the first side surface, and
the transformer and the transistor device are mounted on the substrate such that the plurality of terminal portions are opposed to a side surface other than the first side surface and the second side surface and the control terminal is closer to the plurality of terminal portions than the second terminal.

12. The power supply device according to claim 8,
wherein
the transistor device includes a rectangular body portion (13a) and has the first terminal formed on a first side surface of the body portion and the second terminal and the control terminal both formed on a second side surface of the body portion opposed to the first side surface, and
the transformer and the transistor device are mounted on the substrate such that the plurality of terminal portions are opposed to the first side surface.

13. The power supply device according to claim 1,
wherein
a protrusion height (H2) of the switch element from the second surface of the substrate is smaller than a protrusion height (H1) of the transformer from the first surface of the substrate.

14. The power supply device according to claim 1,
wherein
the transformer is so formed that a plane area thereof is larger than a plane area of the switch element, and the transformer having a larger plane area is arranged in a vertical position higher than a vertical position of the switch element.

15. The power supply device according to claim 1,
wherein
the transformer includes a terminal portion (15a) connected to a primary winding on a primary side and a terminal portion (15c) connected to a secondary winding on a secondary side, and
the terminal portion connected to the primary winding is arranged in a vertical position lower than a vertical position of the terminal portion connected to the secondary winding.
